(19) Europäisches Patentamt
European Patent Office
Office européen des brevets

(11) **EP 4 738 701 A1**

(12) **EUROPEAN PATENT APPLICATION**

(43) Date of publication:
**06.05.2026 Bulletin 2026/19**

(21) Application number: **25212105.8**

(22) Date of filing: **29.10.2025**

(51) International Patent Classification (IPC):
**H03F 1/08** *(2006.01)* **H03F 1/32** *(2006.01)*
**H03F 3/45** *(2006.01)*

(52) Cooperative Patent Classification (CPC):
**H03F 3/45475; H03F 1/086; H03F 1/3211;**
H03F 2200/541; H03F 2203/45512

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **31.10.2024 US 202418933557**

(71) Applicant: **Avago Technologies International
Sales
Pte. Limited
Singapore 768923 (SG)**

(72) Inventors:
• **Chuai, Kun**
**Laguna Niguel, 92677 (US)**
• **Tong, Haitao**
**Laguna Hills, 92653 (US)**
• **Liu, Yang**
**Irvine, 92618 (US)**
• **Cui, Delong**
**Tustin, 92782 (US)**

(74) Representative: **Dilg, Haeusler, Schindelmann
Patentanwaltsgesellschaft mbH
Leonrodstraße 58
80636 München (DE)**

(54) **DYNAMICALLY-TUNABLE AMPLIFIER**

(57) An electronic circuit including an amplifier, a first variable capacitance and a second variable capacitance. The amplifier receives an input signal across an inverting input terminal of the amplifier and a non-inverting input terminal of the amplifier. The first variable capacitance is electrically directly connected to the output terminal of the amplifier and the inverting input terminal of the amplifier. The second variable capacitance is electrically directly connected to the output terminal of the amplifier and the non-inverting input terminal of the amplifier.

**FIG. 1 – System 100**

## Description

## BACKGROUND

In electronics, an amplifier is circuitry designed to convert an input current into a voltage that is amplified. While converting the input current into the voltage, the amplifier multiplies the input current by an amplifier gain to produce the amplified voltage.

## BRIEF DESCRIPTION OF DRAWINGS

The accompanying drawings, which are incorporated in and form a part of this specification, illustrate examples of the disclosure and, together with the description, explain principles of the examples.

FIG. 1 illustrates a functional block diagram of an exemplary system, in accordance with one or more embodiments of the disclosure.

FIG. 2 illustrates an exemplary electronic circuit, in accordance with one or more embodiments of the disclosure.

FIG. 3 illustrates exemplary configurations for variable capacitances, in accordance with one or more embodiments of the disclosure.

FIG. 4 illustrates exemplary configurations for variable resistances, in accordance with one or more embodiments of the disclosure.

In the drawings, like reference symbols and numerals indicate the same or similar components. Like elements in the various figures are denoted by like reference symbols and numerals for consistency. Unless otherwise indicated, like elements and method steps are referred to with like reference numerals.

## DETAILED DESCRIPTION OF THE INVENTION

The following describes technical solutions in this specification with reference to the accompanying drawings. Exemplary embodiments are described in detail with reference to the accompanying drawings.

The terminology used herein is for describing various examples only, and is not to be used to limit the disclosure. Unless otherwise defined, all terms, including technical and scientific terms, used herein have the same meaning as commonly understood by one of ordinary skill in the art to which this disclosure pertains and after an understanding of the disclosure of this application.

Terms, such as those defined in commonly used dictionaries, are to be interpreted as having a meaning that is consistent with their meaning in the context of the relevant art and the disclosure of this application. Although the present technology has been described by referring to certain examples, workers skilled in the art will recognize that changes could be made in form and detail without departing from the scope of the discussion.

In general, the frequency response in many high-speed amplifiers is not flat across all frequencies. Instead, a peaking frequency of an amplifier is the frequency at which the amplifier's gain reaches a maximum point before rolling off due to bandwidth limitations. In high-speed amplifiers, factors such as parasitic capacitances and inductances in the amplifier, any feedback resistors in the amplifier, and the overall amplifier characteristics can cause a resonance that increases the amplifier gain at the peaking frequency. Such increasing of the amplifier gain at the peaking frequency is generally referred to as peaking. Peaking typically appears in the frequency response of the amplifier. In the frequency response for some amplifiers, the amplifier gain is highest at the peaking frequency before decreasing as the frequency continues to increase.

Peaking quantifies how much the amplifier gain increases at the peaking frequency compared to the flat or nominal gain level of the amplifier. An amount of the peaking is often expressed in decibels (dB) as the difference between a nominal amplifier gain level and the amplifier gain at the peaking frequency. The peaking amount quantifies how much the amplifier gain rises above the nominal or expected gain before it begins to roll off at higher frequencies.

Resonance can cause a peak in the frequency response before the gain rolls off at higher frequencies. Resonance is the condition where inductive and capacitive reactances in the amplifier cancel out, thereby causing maximum signal amplification at a resonant frequency. In cases where the resonant frequency coincides with the peaking frequency, both the natural resonance and peaking effects can reinforce each other, leading to a sharp amplification of the input current at the peaking frequency. This sharp amplification can result in distortion in the amplifier. Accordingly, there is a need in the art for an improved amplifier.

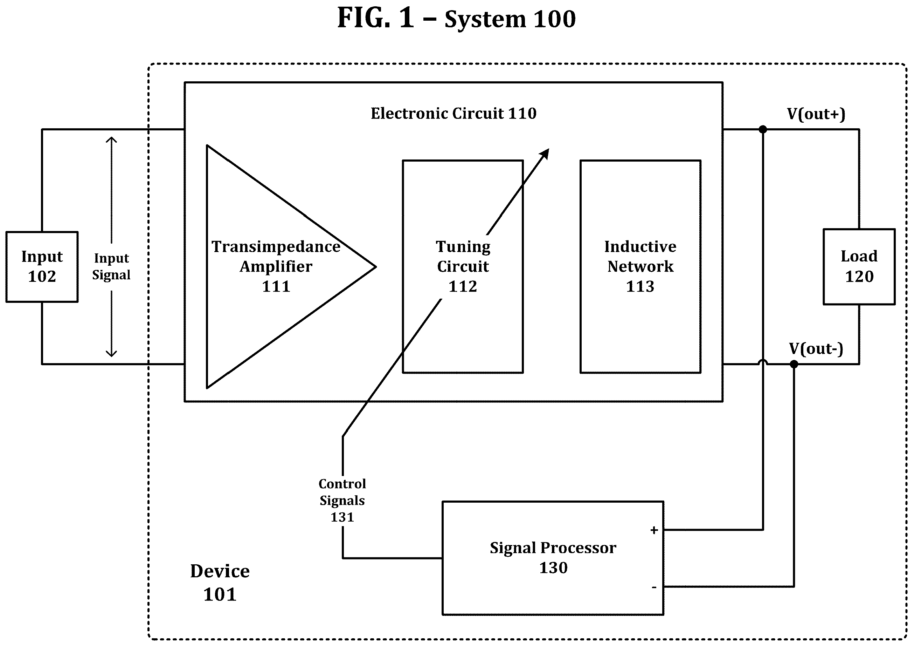

Referring now to FIG. 1, an example system 100 is illustrated. System 100 may include device 101 and input 102. Those skilled in the art will appreciate there may be additional components in system 100.

Device 101 may be any electronic device capable of electronically exchanging information with input 102. Device 101 may be any type of electrically-powered device having computing capability. For example, device 101 may be a computer terminal, a laptop computer, a tablet computer, and/or any other computing device. In some examples, device 101 may be telephone, a mobile phone, a smart phone, a cell phone and/or any other electronic telecommunications device. In other examples, device 101 may be a television set, a video device such as a video display, a video recorder, a digital video recorder (DVR), a set-top box, a set-back box and/or any other electronic entertainment device.

Device 101 may be a sensor, a power-over-ethernet device, a printer, an appliance (e.g., a washer, dryer, refrigerator, oven and/or other appliance), an internet of things (IOT) device and/or any other electronic device that is capable of electrically communicating with input 102.

Device 101 may be any portable electronic device that can be carried by or worn on a person. For example, device 101 may be configured as a wearable device, a smartwatch, a fitness tracker or a personal digital assistant (PDA).

In some examples, device 101 may be found in apparatuses such as autonomous vehicles, robots and drones. Device 101 may be configured as a driver assistance module in a vehicle, a computing device for a vehicle and/or entertainment device for a vehicle. A device 101 may include a network interface card, a router, a server, a hub, a network switch, a modem, a bridge, an access point, a gateway, and/or mesh network interface. Device 101 may be found in an artificial intelligence (AI) network.

Input 102 may be any electronic circuitry capable of providing the input signal to electronic circuit 110. For example, input 102 may be a photodiode, a photomultiplier tube, an ultrasound transducer, and/or a radiation detector. In some implementations, input 102 may be a capacitive sensor, a temperature sensor, an electrochemical sensor, a biosensor, and/or a magnetic field sensor. In other examples, input 102 may be an ethernet device, an optical receiver, an optical transceiver, a fiber-optic receiver, a fiber-optic transceiver, an infrared (IR) receiver, an IR transceiver, a radio frequency (RF) receiver, an RF transceiver, a microwave receiver, a microwave transceiver, an ultrasound receiver, an ultrasound transceiver, a cellular receiver, a cellular transceiver, a global positioning system (GPS) receiver, a GPS transceiver, a satellite communication receiver, a satellite communication transceiver, a television signal receiver, a Wi-Fi receiver, a Wi-Fi transceiver, an audio receiver and/or an audio transceiver. The list above is not intended to be exhaustive. Instead, input 102 may be any current source. Likewise, any voltage source may be input 102.

Device 101 may include electronic circuit 110, load 120 and signal processor 130. Those skilled in the art will appreciate there may be additional components in device 101.

Electronic circuit 110 may be an electronic circuit that may convert an input signal from input 102 into a differential signal. At its output, electronic circuit 110 may produce voltages V(out+) and V(out-), as will be explained in detail. Included in electronic circuit 110 are transimpedance amplifier 111, tuning circuit 112 and inductive network 113. Electronic circuit 110 may be a continuous-time linear equalizer (CTLE). In some examples, an integrated circuit chip may include electronic circuit 110.

Load 120 is an impedance that electronic circuit 110 happens to be driving. Load 120 may be an electronic circuit and/or an electronic device. Electronic circuit 110 may supply voltages V(out+) and V(out-) to load 120. Electronic circuit 110 may drive load 120.

Signal processor 130 is electronic circuitry designed to condition voltages V(out+) and V(out-). To condition voltages V(out+) and V(out-), control signals 131 from signal processor 130 may cause tuning circuit 112 to adjust a peaking frequency of voltages V(out+) and V(out-), as will be discussed in detail.

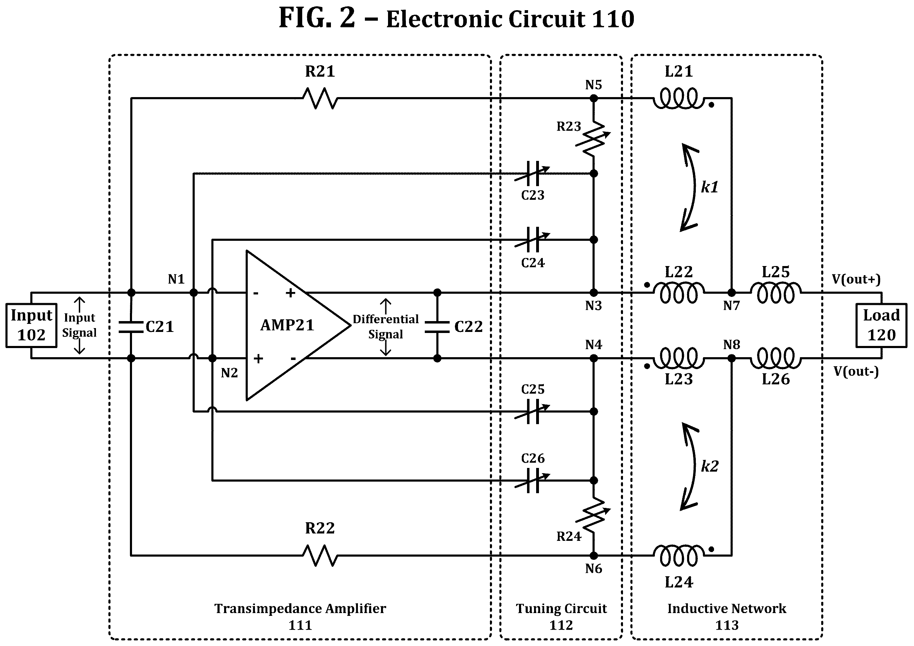

Turning now to FIG. 2, an exemplary electronic circuit 110 is illustrated. Electronic circuit 110 may amplify the input signal to convert the input signal into an amplified signal. Gain is the ratio of the amplified signal (voltage, current, or power) to the input signal. Gain, which is typically expressed as a dimensionless ratio or in decibels (dB), quantifies an amount of increase in the amplitude of the input signal in cases where electronic circuit 110 converts the input signal into the amplified signal.

While converting the input current into the amplified signal, electronic circuit 110 may multiply the input current by the gain to produce the amplified signal. The amplified signal being a differential signal is within the scope of the invention, as illustrated in FIG. 2. A voltage level of the differential signal is proportional the input signal. The amplified signal could be out of phase by 180 degrees from the input signal. Electronic circuit 110 may include transimpedance amplifier 111, tuning circuit 112 and inductive network 113. Electronic circuit 110 may also include nodes N1-N8.

As illustrated in FIG. 2, transimpedance amplifier 111 may include components such as feedback resistors R21 and R22, the total lumped capacitance C21, output filter capacitor C22 and amplifier AMP21. Amplifier AMP21 is a differential amplifier. A differential amplifier is an electronic component having a pair of differential inputs and a pair of differential outputs. In the example of FIG. 2, the pair of differential inputs in amplifier AMP21 may include an inverting input terminal (-) and a noninverting input terminal (+).

Referred to herein, "electrically connected directly," "electrically directly connected" and "directly electrically connected " mean that two or more components are connected along a conductive path without any intermediary component therebetween. The inverting input terminal (-) is electrically directly connected to node N1. The non-inverting input terminal (+) is electrically directly connected to node N2. The pair of differential outputs in amplifier AMP21 may include an inverting output terminal (-) and a non-inverting output terminal (+). The non-inverting output terminal (+) is electrically directly connected to node N3. The inverting output terminal (-) is electrically directly connected to node N4.

A total lumped capacitance C21 is electrically directly connected to node N1 and node N2, as illustrated in FIG. 2. The total lumped capacitance C21 may be described as the capacitance at the input of transimpedance amplifier 111 along with the parasitic capacitance at node N1 and node N2. As such, the total lumped capacitance C21 is electrically directly connected to the inverting input terminal (-) and the non-inverting input terminal (+) of amplifier AMP21. The input signal may appear across the total lumped capacitance C21. In this manner, amplifier AMP21 may receive the input signal across the inverting input terminal (-) and the non-inverting input terminal (+). The input signal could be a differential signal. The total lumped capacitance C21 may filter out high-frequency common-mode noise from the input signal, may improve stability by inhibiting high-frequency oscillations, and may provide bandwidth control for amplifier AMP21.

Amplifier AMP21 may amplify and convert the input signal into the differential signal. For example, the non-inverting input terminal (+) and the inverting input terminal (-) may receive the input signal as illustrated in FIG. 2. Amplifier AMP21 ignores common-mode noise that may appear equally on both the non-inverting input terminal (+) and the inverting input terminal (-) while amplifying the input signal that appears between the non-inverting input terminal (+) and the inverting input terminal (-). Amplifier AMP21 may multiply the input signal by the gain of amplifier AMP21 to produce an amplified input signal. The differential signal from amplifier AMP21 that appears across the inverting output terminal (-) and the non-inverting output terminal (+) of amplifier AMP21 happens to be the amplified input signal. The differential signal happens to be out of phase by 180 degrees from the input signal. Feedback resistors R21 and R22 may regulate the gain of amplifier AMP21. Feedback resistors R21 and R22 may also stabilize the conversion of the input signal into the differential signal.

Output filter capacitor C22 is electrically directly connected between node N3 and node N4, as illustrated in FIG. 2. As such, output filter capacitor C22 is electrically directly connected between the inverting output terminal (-) and the non-inverting output terminal (+) of amplifier AMP21. The differential signal from amplifier AMP21 may appear across output filter capacitor C22. In some examples, output filter capacitor C22 could be a total lumped capacitance. Output filter capacitor C22 may create a low-pass filter that attenuates unwanted high-frequency components in the differential signal. For example, output filter capacitor C22 may filter high-frequency noise in the differential signal. Output filter capacitor C22 may also smooth out transients in the differential signal.

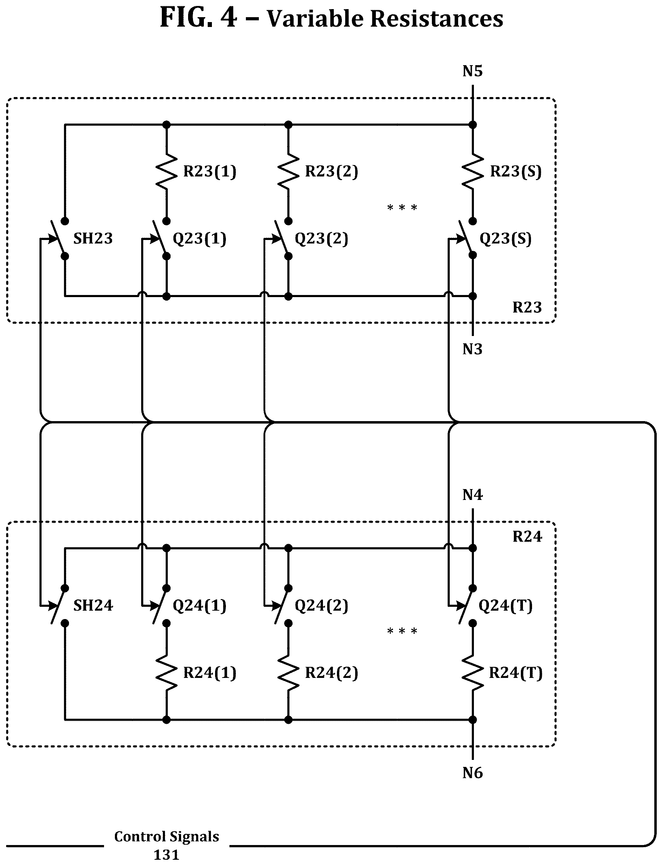

As illustrated in the example of FIG. 2, tuning circuit 112 may include variable resistances R23 and R24. Variable resistances R23 and R24 may each be a variable resistance. A variable resistance is an electrical resistance whose resistive value could be adjusted electronically. Variable resistance R23 is electrically directly connected between node N3 and node N5, as illustrated in FIG. 2. Variable resistance R24 is electrically directly connected between node N4 and node N6. Now turning to FIG. 4, exemplary configurations for variable resistances R23 and R24 are illustrated.

Variable resistance R23 may include resistors R23(1) - R23(S) and switches Q23(1) - Q23(S) with "S" being an integer greater than 1. Any one of the resistors R23(1) - R23(S) could be individually referred to as "resistor R23(i)." Any one of the switches Q23(1) - Q23(S) could be individually referred to as "switch Q23(i)." In some configurations, a resistance for one of the resistors R23(1) - R23(S) may differ from a resistance for another of the resistors R23(1) - R23(S). In other configurations, each of the resistors R23(1) - R23(S) could be of the same resistance.

Control signals 131 from signal processor 130 may independently manage the conductive and non-conductive states of switch SH23 and switches Q23(1) - Q23(S). Being independently controllable, switch SH23 and switches Q23(1) - Q23(S) may operate individually of one another. Control signals 131 from signal processor 130 may cause the opening and closure of switch SH23 and switches Q23(1) - Q23(S). Switch SH23 may cause a controllable shorting of node N3 with N5. For example, control signals 131 from signal processor 130 may cause switch SH23 to become conductive and short circuit node N3 with N5. In response to the closure of switch Q23(i), switch Q23(i) will become conductive and cause the passage of current between nodes N3 and N5 through a corresponding resistor R23(i). In FIG. 4, switch Q23(1) corresponds with resistor R23(1), switch Q23(2) corresponds with resistor R23(2), and switch Q23(S) corresponds with resistor R23(S) by way of illustration. In response to the opening of switch Q23(i), switch Q23(i) will become non-conductive and inhibit the passage of current between nodes N3 and N5 through corresponding resistor R23(i). Two or more of the switches Q23(1) - Q23(S) may become simultaneously conductive in some situations, at least one of the switches Q23(1) - Q23(S) is conductive during each of the situations. In cases where electronic circuit 110 converts the input signal into the differential signal, the opening and closure of switches Q23(1) - Q23(S) may adjust the resistive value of variable resistance R23.

Variable resistance R24 may include resistors R24(1) - R24(T) and switches Q24(1) - Q24(T) with "T" being an integer greater than 1. "T" could be an integer value differing from "S" in some implementations. In other implementations, "S" and "T" may both be the same integer value. Any one of the resistors R24(1) - R24(T) could be individually referred to as "resistor R24(i)." Any one of the switches Q24(1) - Q24(T) could be individually referred to as "switch Q24(i)." In some configurations, a resistance for one of the resistors R24(1) - R24(T) may differ from a resistance for another of the resistors R24(1) - R24(T). In other configurations, each of the resistors R24(1) - R24(T) could be of the same resistance.

Control signals 131 from signal processor 130 may independently manage the conductive and non-conductive states of switch SH24 and switches Q24(1) - Q24(S). Being independently controllable, switch SH24 and switches Q24(1) - Q24(S) may operate individually of one another. Control signals 131 from signal processor 130 may cause the opening and closure of switch SH24 and switches Q24(1) - Q24(S). Switch SH24 may cause a controllable shorting of node N4 with N6. For example, control signals 131 from signal processor 130 may cause switch SH24 to become conductive and short circuit node N4 with N6. In response to the closure of switch Q24(i), switch Q24(i) will become conductive and cause the passage of current between nodes N4 and N6 through a corresponding resistor R24(i). In FIG. 4, switch Q24(1) corresponds with resistor R24(1), switch Q24(2) corresponds with resistor R24(2), and switch Q24(S) corresponds with resistor R24(S) by way of illustration. In response to the opening of switch Q24(i), switch Q24(i) will become non-conductive and inhibit the passage of current between nodes N4 and N6 through corresponding resistor R24(i). Two or more of the switches Q24(1) - Q24(S) may become simultaneously conductive in some situations, at least one of the switches Q24(1) - Q24(S) is conductive during each of the situations. In cases where electronic circuit 110 converts the input signal into the differential signal, the opening and closure of switches Q24(1) - Q24(S) may adjust the resistive value of variable resistance R24.

As illustrated in the example of FIG. 2, tuning circuit 112 may include variable capacitances C23, C24, C26 and C25. A variable capacitance is an electrical capacitance whose capacitive value could be adjusted electronically.

In the example of FIG. 2, variable capacitance C23 is electrically directly connected between node N1 and node N3. The direct electrical connection of variable capacitance C23 between node N1 and node N3 may introduce a negative feedback between inverting input terminal (-) and non-inverting output terminal (+) of amplifier AMP21. Variable capacitance C23 may be a dynamically adjustable positive miller capacitance as a consequence of the negative feedback. Due to the Miller effect, variable capacitance C23 may induce a large positive capacitance in parallel with the total lumped capacitance C21 while also inducing a small positive capacitance in parallel with output filter capacitor C22.

In the example of FIG. 2, variable capacitance C24 is electrically directly connected between node N2 and node N3. The direct electrical connection of variable capacitance C24 between node N2 and node N3 may introduce a positive feedback between non-inverting input terminal (+) and non-inverting output terminal (+) of amplifier AMP21. Variable capacitance C24 may be a dynamically adjustable negative miller capacitance as a consequence of the positive feedback. Due to the Miller effect, variable capacitance C24 may induce a small negative capacitance in parallel with the total lumped capacitance C21 while also inducing a large negative capacitance in parallel with output filter capacitor C22.

In the example of FIG. 2, variable capacitance C25 is electrically directly connected between node N1 and node N4. The direct electrical connection of variable capacitance C25 between node N1 and node N4 may introduce a positive feedback between inverting input terminal (-) and inverting output terminal (-) of amplifier AMP21. Variable capacitance C25 may be a dynamically adjustable negative miller capacitance as a consequence of the positive feedback. Due to the Miller effect, variable capacitance C25 may induce a small negative capacitance in parallel with the total lumped capacitance C21 while also inducing a large negative capacitance in parallel with output filter capacitor C22.

In the example of FIG. 2, variable capacitance C26 is electrically directly connected between node N2 and node N4. The direct electrical connection of variable capacitance C26 between node N2 and node N4 may introduce a negative feedback between non-inverting input terminal (+) and inverting output terminal (-) of amplifier AMP21. Variable capacitance C26 may be a dynamically adjustable positive miller capacitance as a consequence of the negative feedback. Due to the Miller effect, variable capacitance C26 may induce a large positive capacitance in parallel with the total lumped capacitance C21 while also inducing a small positive capacitance in parallel with output filter capacitor C22.

The total lumped capacitance C21 may affect the peaking amount without affecting peaking frequency. The variable capacitance added to the total lumped capacitance C21 due to the dynamically adjusted Miller capacitances C23, C24, C26 and C25 may cause an adjustment of the peaking amount. Consequently, the dynamically adjusted Miller capacitances C23, C24, C26 and C25 may permit a precise adjustment of the peaking amount either without altering the peaking frequency or while scarcely affecting the peaking frequency.

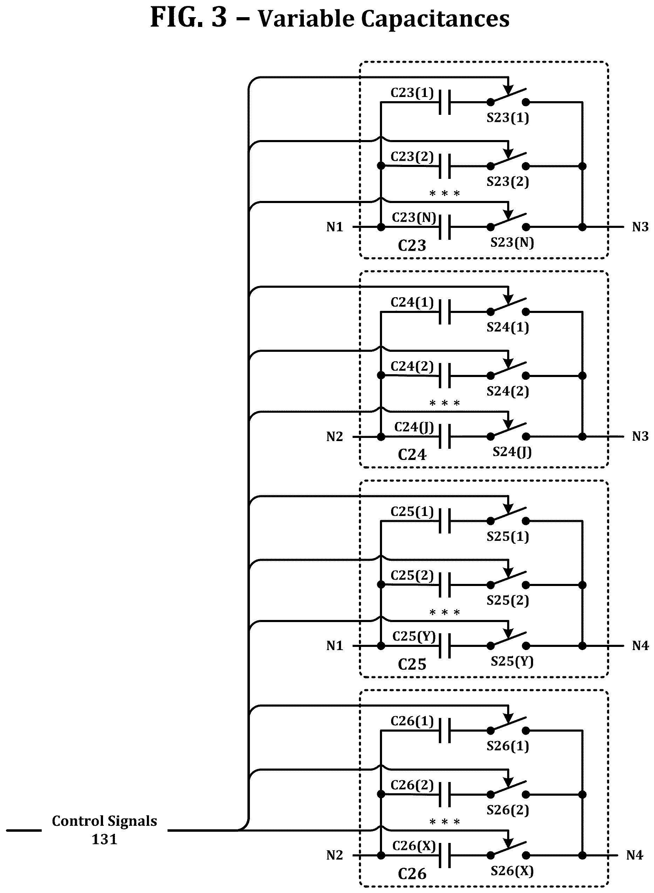

Now turning to FIG. 3, exemplary configurations for variable capacitances C23, C24, C26 and C25 are illustrated.

Variable capacitance C23 may include capacitors C23(1) - C23(N) and switches S23(1) - S23(N) with "N" being an integer greater than 1. In some implementations, "N" could be an integer value differing from "S" and differing from "T." In other implementations, "N," "S" and "T" may all be the same integer value. Any one of the capacitors C23(1) - C23(N) could be individually referred to as "capacitor C23(i)." Any one of the switches S23(1) - S23(N) could be individually referred to as "switch S23(i)." Switch S23(i) is in series with capacitor C23(i). In some configurations, a capacitance for one of the capacitors C23(1) - C23(N) may differ from a capacitance for another of the capacitors C23(1) - C23(N). In other configurations, each of the capacitors C23(1) - C23(N) could be of the same capacitance.

Control signals 131 from signal processor 130 may independently manage the conductive and non-conductive states of switches S23(1) - S23(N). Being independently controllable, switches S23(1) - S23(N) may operate individually of one another. Control signals 131 from signal processor 130 may cause the opening and closure of switches S23(1) - S23(N). In response to the closure of switch S23(i), switch S23(i) will become conductive and cause the passage of current between nodes N1 and N3 through a corresponding capacitor C23(i). In FIG. 3, switch S23(1) corresponds with capacitor C23(1), switch S23(2) corresponds with capacitor C23(2), and switch S23(N) corresponds with capacitor C23(N) by way of illustration. In response to the opening of switch S23(i), switch S23(i) will become non-conductive and inhibit the passage of current between nodes N1 and N3 through corresponding capacitor C23(i). Although two or more of the switches S23(1) - S23(N) may become simultaneously conductive in some situations, at least one of the switches S23(1) - S23(N) is conductive during each of the situations. In cases where electronic circuit 110 converts the input signal into the differential signal, the opening and closure of switches S23(1) - S23(N) may adjust the capacitive value of variable capacitance C23.

Variable capacitance C24 may include capacitors C24(1) - C24(J) and switches S24(1) - S24(J) with "J" being an integer greater than 1. In some implementations, "J" could be an integer value differing from "N," differing from "S" and differing from "T." In other implementations, "J," "N," "S" and "T" may all be the same integer value. Any one of the capacitors C24(1) - C24(J) could be individually referred to as "capacitor C24(i)." Any one of the switches S24(1) - S24(J) could be individually referred to as "switch S24(i)." Switch S24(i) is in series with capacitor C24(i). In some configurations, a capacitance for one of the capacitors C24(1) - C24(J) may differ from a capacitance for another of the capacitors C24(1) - C24(J). In other configurations, each of the capacitors C24(1) - C24(J) could be of the same capacitance.

Control signals 131 from signal processor 130 may independently manage the conductive and non-conductive states of switches S24(1) - S24(J). Being independently controllable, switches S24(1) - S24(J) may operate individually of one another. Control signals 131 from signal processor 130 may cause the opening and closure of switches S24(1) - S24(J). In response to the closure of switch S24(i), switch S24(i) will become conductive and cause the passage of current between nodes N1 and N3 through a corresponding capacitor C24(i). In FIG. 3, switch S24(1) corresponds with capacitor C24(1), switch S24(2) corresponds with capacitor C24(2), and switch S24(J) corresponds with capacitor C24(J) by way of illustration. In response to the opening of switch S24(i), switch S24(i) will become non-conductive and inhibit the passage of current between nodes N1 and N3 through corresponding capacitor C24(i). Although two or more of the switches S24(1) - S24(J) may become simultaneously conductive in some situations, at least one of the switches S24(1) - S24(J) is conductive during each of the situations. In cases where electronic circuit 110 converts the input signal into the differential signal, the opening and closure of switches S24(1) - S24(J) may adjust the capacitive value of variable capacitance C24.

Variable capacitance C26 may include capacitors C26(1) - C26(X) and switches S26(1) - S26(X) with "X" being an integer greater than 1. In some implementations, "X" could be an integer value differing from "J," differing from "N," differing from "S" and differing from "T." In other implementations, "X," "J," "N," "S" and "T" may all be the same integer value. Any one of the capacitors C26(1) - C26(X) could be individually referred to as "capacitor C26(i)." Any one of the switches S26(1) - S26(X) could be individually referred to as "switch S26(i)." Switch S26(i) is in series with capacitor C26(i). In some configurations, a capacitance for one of the capacitors C26(1) - C26(X) may differ from a capacitance for another of the capacitors C26(1) - C26(X). In other configurations, each of the capacitors C26(1) - C26(X) could be of the same capacitance.

Control signals 131 from signal processor 130 may independently manage the conductive and non-conductive states of switches S26(1) - S26(X). Being independently controllable, switches S26(1) - S26(X) may operate individually of one another. Control signals 131 from signal processor 130 may cause the opening and closure of switches S26(1) - S26(X). In response to the closure of switch S26(i), switch S26(i) will become conductive and cause the passage of current between nodes N2 and N4 through a corresponding capacitor C26(i). In FIG. 3, switch S26(1) corresponds with capacitor C26(1), switch S26(2) corresponds with capacitor C26(2), and switch S26(X) corresponds with capacitor C26(X) by way of illustration. In response to the opening of switch S26(i), switch S26(i) will become non-conductive and inhibit the passage of current between nodes N2 and N4 through corresponding capacitor C26(i). Although two or more of the switches S26(1) - S26(X) may become simultaneously conductive in some situations, at least one of the switches S26(1) - S26(X) is conductive during each of the situations. In cases where electronic circuit 110 converts the input signal into the differential signal, the opening and closure of switches S26(1) - S26(X) may adjust the capacitive value of variable capacitance C26.

Variable capacitance C25 may include capacitors C25(1) - C25(Y) and switches S25(1) - S25(Y) with "Y" being an integer greater than 1. In some implementations, "Y" could be an integer value differing from "X," differing from "J," differing from "N," differing from "S" and differing from "T." In other implementations, "X," "Y," "J," "N," "S" and "T" may all be the same integer value. Any one of the capacitors C25(1) - C25(Y) could be individually referred to as "capacitor C25(i)." Any one of the switches S25(1) - S25(Y) could be individually referred to as "switch S25(i)." Switch S25(i) is in series with capacitor C25(i). In some configurations, a capacitance for one of the capacitors C25(1) - C25(Y) may differ from a capacitance for another of the capacitors C25(1) - C25(Y). In other configurations, each of the capacitors C25(1) - C25(Y) could be of the same capacitance.

Control signals 131 from signal processor 130 may independently manage the conductive and non-conductive states of switches S25(1) - S25(Y). Being independently controllable, switches S25(1) - S25(Y) may operate individually of one another. Control signals 131 from signal processor 130 may cause the opening and closure of switches S25(1) - S25(Y). In response to the closure of switch S25(i), switch S25(i) will become conductive and cause the passage of current between nodes N2 and N4 through a corresponding capacitor C25(i). In FIG. 3, switch S25(1) corresponds with capacitor C25(1), switch S25(2) corresponds with capacitor C25(2), and switch S25(Y) corresponds with capacitor C25(Y) by way of illustration. In response to the opening of switch S25(i), switch S25(i) will become non-conductive and inhibit the passage of current between nodes N2 and N4 through corresponding capacitor C25(i). Although two or more of the switches S25(1) - S25(Y) may become simultaneously conductive in some situations, at least one of the switches S25(1) - S25(Y) is conductive during each of the situations. In cases where electronic circuit 110 converts the input signal into the differential signal, the opening and closure of switches S25(1) - S25(Y) may adjust the capacitive value of variable capacitance C25.

As illustrated in the example of FIG. 2, inductive network 113 may include inductors L21-L26. Inductor L21 is electrically directly connected between node N5 and node N7. Inductor L22 is electrically directly connected between node N3 and node N7. Inductor L25 is electrically directly connected between node N7 and load 120. Inductor L23 is electrically directly connected between node N4 and node N8. Inductor L26 is electrically directly connected between node N8 and load 120. Inductor L24 is electrically directly connected between node N8 and node N8. In some configurations, an inductance for one of the inductors L21-L26 may differ from an inductance for another of the inductors L21-L26. In other configurations, each of the inductors L21-L26 could be of the same inductance.

Mutually-coupled inductors are two or more inductors that are in close proximity with one another. Inductive coupling between the inductors is a result of mutual inductance, which occurs when a change in current in one inductor generates a changing magnetic flux that links an inductor to the other inductor. As illustrated in the example of FIG. 2, a pair of mutually-coupled inductors may include inductors L21 and L22. Being mutually-coupled inductors, the magnetic field generated by the current flowing through one of the inductors L21 and L22 may induce a voltage in the other of the inductors L21 and L22. Another pair of mutually-coupled inductors may include inductors L23 and L24. Similarly, the magnetic field generated by the current flowing through one of the inductors L23 and L24 may induce a voltage in the other of the inductors L23 and L24.

Mutual inductance could be calculated according to the following formula:

$$M = k \times \sqrt{L1 \times L2}$$

where,

"M" is mutual inductance,
"k" is the coupling coefficient,
"L1" is the inductance of the first inductor, and
"L2" is the inductance of the second inductor.

Coupling coefficient (k) indicates the strength of the coupling between the first and second inductors. Specifically, coupling coefficient (k) is an indicator that quantifies how much of the magnetic flux from one inductor may link with the other inductor. Coupling coefficient (k), which is a unitless value, ranges from "0" for no coupling to "1" for perfect coupling. Perfect coupling may occur in cases where the magnetic field produced by one inductor is completely linked with another inductor, resulting in 100% transfer of magnetic flux between the two inductors. A 100% transfer of magnetic flux between the two inductors may occur in cases where all the magnetic energy generated by the current in one inductor is transferred to the other inductor. The example of FIG. 2 illustrates coupling coefficient (k1) between inductors L21, L22 and coupling coefficient (k2) between inductors L23, L24.

Mutually-coupled inductors L21 and L22 may each include a polarity dot that indicates a relative polarity of the voltages induced in inductors L21 and L22. Polarity dots are depicted in FIG. 2 adjacent to inductors L21-L22. By way of illustration, the terminal of inductor L21 that is connected to node N7 happens to be associated with a polarity dot for inductor L21. The terminal of inductor L22 that is connected to node N3 happens to be associated with a polarity dot for inductor L22. The polarity dots indicate the relative polarity of the mutual inductance between the windings of the inductors L21-L22. For example, in cases where currents flow in the windings of the inductors L21- L22, the induced voltage at the dot of inductor L21 will have a polarity opposite to the voltage at the dot of inductor L22.

Mutually-coupled inductors L23 and L24 may each include a polarity dot that indicates a relative polarity of the voltages induced in inductors L23 and L24. Polarity dots are depicted in FIG. 2 adjacent to inductors L23-L24. By way of illustration, the terminal of inductor L23 that is connected to node N4 happens to be associated with a polarity dot for inductor L23. The terminal of inductor L24 that is connected to node N8 happens to be associated with a polarity dot for inductor L24. The polarity dots indicate the relative polarity of the mutual inductance between the windings of the inductors L23-L24. For example, in cases where currents flow in the windings of the inductors L23- L24, the induced voltage at the dot of inductor L23 will have a polarity opposite to the voltage at the dot of inductor L24.

Variable resistances R23 and R24 may each be a dynamically adjustable resistance that is dynamically adjustable, as previously explained in detail. Being dynamically adjustable, variable resistances R23 and R24 may individually regulate resistances in electronic circuit 110. For example, variable resistance R23 may regulate any resistance that happens to exist between nodes N3 and N5. Variable resistance R24 may regulate any resistance that happens to exist between nodes N4 and N6. In cases where variable resistances R23 and R24 regulate resistances in electronic circuit 110, variable resistances R23 and R24 may individually regulate the quality factor (Q-factor) of electronic circuit 110. The Q factor quantifies the sharpness or selectivity of a resonance in electronic circuit 110.

While regulating the quality factor (Q-factor) of electronic circuit 110, variable resistances R23 and R24 may individually adjust the effectiveness of inductors L21-L24 to thereby lower the Q-factor of electronic circuit 110. Lowering the Q-factor of electronic circuit 110 may cause electronic circuit 110 to become less selective, broaden the bandwidth of electronic circuit 110 and in turn reduce the peaking amount at the peaking frequency.

Variable resistances R23 and R24 may permit a precise tuning of the peaking frequency. Variable capacitances C23, C24, C26 and C25 may permit a precise adjustment of the peaking amount either without altering the peaking frequency or while scarcely affecting the peaking frequency. Precision in dynamically adjusting the peaking amount and dynamically tuning the peaking frequency is an improvement that may ensure a superior frequency response for electronic circuit 110 across diverse communication channels, speeds and encoding schemes.

Those skilled in the art will also appreciate the arrangement or interconnection of components such as "coupled," "connected," "on," "under," or similar wording allows for indirect connections, or intervening components or layers.

Certain operations of methods according to the technology, or of systems executing those methods, may be represented schematically in the figures or otherwise discussed herein. Unless otherwise specified or limited, representation in the figures of particular operations in particular spatial order may not necessarily require those operations to be executed in a particular sequence corresponding to the particular spatial order. Correspondingly, certain operations represented in the figures, or otherwise disclosed herein, may be executed in different orders than are expressly illustrated or described, as appropriate for particular examples of the technology. Further, in some examples, certain operations may be executed in parallel or partially in parallel, including by dedicated parallel processing devices, or separate computing devices configured to interoperate as part of a large system.

As used herein, unless otherwise limited or defined, "or" indicates a non-exclusive list of components or operations that may be present in any variety of combinations, rather than an exclusive list of components that may be present only as alternatives to each other. For example, a list of "A, B, or C" indicates options of: A; B; C; A and B; A and C; B and C; and A, B, and C.

Correspondingly, the term "or" as used herein is intended to indicate exclusive alternatives only when preceded by terms of exclusivity, such as, e.g., "either," "only one of," or "exactly one of." Further, a list preceded by "one or more" (and variations thereon) and including "or" to separate listed elements indicates options of one or more of any or all of the listed elements.

For example, the phrases "one or more of A, B, or C" and "at least one of A, B, or C" indicate options of: one or more A; one or more B; one or more C; one or more A and one or more B; one or more B and one or more C; one or more A and one or more C; and one or more of each of A, B, and C.

Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In general, the term "or" as used herein only indicates exclusive alternatives (e.g., "one or the other but not both") when preceded by terms of exclusivity, such as, e.g., "either," "only one of," or "exactly one of."

Any mark, if referenced herein, may be common law or registered trademarks of third parties affiliated or unaffiliated with the applicant or the assignee. Use of these marks is by way of example and shall not be construed as descriptive or to limit the scope of disclosed or claimed embodiments to material associated only with such marks.

The articles "a," "an," and "the" are intended to include the plural forms as well, unless the context clearly indicates otherwise.

The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Throughout the application, ordinal numbers (e.g., first, second, third, etc.) may be used as an adjective for an element (i.e., any noun in the application).

Although terms such as "first," "second," and "third" may be used herein to describe various members, components, regions, layers, or sections, these members, components, regions, layers, or sections are not to be limited by these terms.

Rather, these terms are only used to distinguish one member, component, region, layer, or section from another member, component, region, layer, or section.

The use of ordinal numbers is not to imply or create any particular ordering of the elements nor to limit any element to being only a single element unless expressly disclosed, such as by the use of the terms "before," "after," "single," and other such terminology.

Rather, the use of ordinal numbers is to distinguish between the elements.

By way of an example, a first element is distinct from a second element, and the first element may encompass more than one element and succeed (or precede) the second element in an ordering of elements.

Thus, a first member, component, region, layer, or section referred to in examples described herein may also be referred to as a second member, component, region, layer, or section without departing from the teachings of the examples.

## Claims

1. An electronic circuit comprising:

an amplifier, the amplifier is configured to receive an input signal across an inverting input terminal of the amplifier and a non-inverting input terminal of the amplifier;
a first variable capacitance, the first variable capacitance is electrically directly connected to an output terminal of the amplifier and the inverting input terminal of the amplifier; and
a second variable capacitance, the second variable capacitance is electrically directly connected to the output terminal of the amplifier and the non-inverting input terminal of the amplifier.

2. The electronic circuit according to claim 1, wherein

the first variable capacitance comprises a plurality of capacitors;
and/or
the second variable capacitance comprises a plurality of capacitors.

3. The electronic circuit according to claim 1 or 2, wherein

the output terminal of the amplifier is a non-inverting output terminal of the amplifier;
or wherein
the output terminal of the amplifier is an inverting output terminal of the amplifier.

4. The electronic circuit according to any one of the claims 1 to 3, wherein
the first variable capacitance is electrically connected between the output terminal of the amplifier and the inverting input terminal of the amplifier.

5. The electronic circuit according to any one of the claims 1 to 4, wherein
the second variable capacitance is electrically connected between the output terminal of the amplifier and the non-inverting input terminal of the amplifier.

6. The electronic circuit according to any one of the claims 1 to 5, wherein
the amplifier is configured to output, in response to amplifying the input signal, an amplified signal onto the output terminal of the amplifier.

7. The electronic circuit according to claim 6, wherein
the amplifier is configured to convert, by amplifying the input signal, the input signal into the amplified signal.

8. The electronic circuit according to any one of the claims 1 to 7, further comprising:
a first inductor, the first inductor is electrically directly connected to the output terminal of the amplifier.

9. The electronic circuit according to claim 8, further comprising:
a second inductor, the second inductor is electrically directly connected to a variable resistance and the first inductor.

10. The electronic circuit according to claim 9, wherein
a pair of mutually-coupled inductors comprises the first inductor and the second inductor.

11. The electronic circuit according to claim 9 or 10, further comprising:
the variable resistance, the variable resistance is electrically directly connected to the output terminal of the amplifier;

wherein in particular
the electronic circuit comprises at least one of the following features:

(A) the variable resistance comprises a plurality of variable resistors; and
(B) the electronic circuit further comprises a feedback resistor, the feedback resistor is electrically directly connected to the variable resistance and the non-inverting input terminal of the amplifier.

12. The electronic circuit according to any one of the claims 1 to 11, further comprising:
a capacitor, the capacitor is electrically directly connected to the non-inverting input terminal of the amplifier and the inverting input terminal of the amplifier;

wherein in particular
the capacitor is electrically directly connected across the inverting input terminal of the amplifier and the non-inverting input terminal of the amplifier.

13. A device comprising:

a load, the load is configured to receive a differential voltage; and
an electronic circuit, wherein the electronic circuit comprises:

an amplifier, the amplifier is configured to receive an input signal across an inverting input terminal of the amplifier and a non-inverting input terminal of the amplifier;
a first variable capacitance, the first variable capacitance is electrically directly connected to an output terminal of the amplifier and the inverting input terminal of the amplifier; and
a second variable capacitance, the second variable capacitance is electrically directly connected to the output terminal of the amplifier and the non-inverting input terminal of the amplifier.

wherein the amplifier is configured to convert, by amplifying the input signal, the input signal into the differential voltage.

14. The device according to claim 13, wherein an integrated circuit comprises the electronic circuit.

15. A system comprising:

an input source, the input source is configured to output an input signal;
an electronic circuit, wherein the electronic circuit comprises:

an amplifier, the amplifier is configured to receive the input signal across an inverting input terminal of the amplifier and a non-inverting input terminal of the amplifier;
a first variable capacitance, the first variable capacitance is electrically directly connected to an output terminal of the amplifier and the inverting input terminal of the amplifier; and
a second variable capacitance, the second variable capacitance is electrically directly connected to the output terminal of the amplifier and the non-inverting input terminal of the amplifier.

# FIG. 1 – System 100

EP 4 738 701 A1

FIG. 2 – Electronic Circuit 110

# FIG. 3 – Variable Capacitances

# FIG. 4 – Variable Resistances

## EUROPEAN SEARCH REPORT

Application Number

EP 25 21 2105

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/170628 A1 (OISHI KAZUAKI [JP] ET AL) 14 July 2011 (2011-07-14) | 1-8, 12-15 | INV. H03F1/08 H03F1/32 H03F3/45 |
| A | * paragraphs [0151] - [0160]; figures 18,19B * | 9-11 | |
| X | US 2021/105007 A1 (CHANG JISOO [KR]) 8 April 2021 (2021-04-08) | 1,2, 12-15 | |
| A | * paragraph [0002]; figure 2 * | 3-11 | |
| A | US 4 414 690 A (NORDHOLT ERNST H [NL] ET AL) 8 November 1983 (1983-11-08) * abstract; figures 3,4 * | 1-15 | |
| A | CN 114 002 891 A (UNITED MICROELECTRONICS CENTER CO LTD) 1 February 2022 (2022-02-01) * abstract; figures 1,5 * | 1-15 | |

TECHNICAL FIELDS
SEARCHED     (IPC)

H03F

The present search report has been drawn up for all claims

| Place of search | Date of completion of the search | Examiner |
|---|---|---|
| The Hague | 4 February 2026 | Zakharian, Andre |

EPO FORM 1503 03.82 (P04C01)

## ANNEX TO THE EUROPEAN SEARCH REPORT
## ON EUROPEAN PATENT APPLICATION NO.

EP 25 21 2105

This annex lists the patent family members relating to the patent documents cited in the above-mentioned European search report.
The members are as contained in the European Patent Office EDP file on
The European Patent Office is in no way liable for these particulars which are merely given for the purpose of information.

04-02-2026

| Patent document cited in search report | Publication date | Patent family member(s) | Publication date |
|---|---|---|---|
| US 2011170628 A1 | 14-07-2011 | JP 5834377 B2<br>JP 2011146861 A<br>US 2011170628 A1 | 24-12-2015<br>28-07-2011<br>14-07-2011 |
| US 2021105007 A1 | 08-04-2021 | KR 20210041358 A<br>US 2021105007 A1 | 15-04-2021<br>08-04-2021 |
| US 4414690 A | 08-11-1983 | AU 544852 B2<br>CA 1173559 A<br>DE 3124331 A1<br>FR 2485276 A1<br>GB 2079064 A<br>HK 52688 A<br>JP H03802 B2<br>JP S5730403 A<br>NL 8003566 A<br>US 4414690 A | 13-06-1985<br>28-08-1984<br>01-04-1982<br>24-12-1981<br>13-01-1982<br>22-07-1988<br>09-01-1991<br>18-02-1982<br>18-01-1982<br>08-11-1983 |
| CN 114002891 A | 01-02-2022 | NONE | |

EPO FORM P0459

For more details about this annex : see Official Journal of the European Patent Office, No. 12/82